Europäisches Patentamt

European Patent Office

Office européen des brevets

(11) Veröffentlichungsnummer: **0 549 881 A1**

## EUROPÄISCHE PATENTANMELDUNG

(21) Anmeldenummer: **92119939.4**

(22) Anmeldetag: **24.11.92**

(51) Int. Cl.5: **H03L 7/23**

(30) Priorität: **29.11.91 DE 4139342**

(43) Veröffentlichungstag der Anmeldung:
**07.07.93 Patentblatt 93/27**

(84) Benannte Vertragsstaaten:
**AT BE CH DE ES FR GB IT LI NL SE**

(71) Anmelder: **Alcatel SEL Aktiengesellschaft**
**Lorenzstrasse 10**
**W-7000 Stuttgart 40(DE)**

(84) **DE**

(71) Anmelder: **ALCATEL N.V.**
**Strawinskylaan 341 (World Trade Center)**
**NL-1077 XX Amsterdam(NL)**

(84) **BE CH ES FR GB IT LI NL SE AT**

(72) Erfinder: **Künl, Otmar**
**Buchenstrasse 19**
**W-7531 Neulingen(DE)**
Erfinder: **Dietrich, Klaus**
**Kurze Steige 31**
**W-7530 Pforzheim(DE)**

(74) Vertreter: **Brose, Gerhard et al**
**Alcatel SEL AG Patent- und Lizenzwesen**
**Postfach 30 09 29**
**W-7000 Stuttgart 30 (DE)**

(54) **Frequenzsynthetisierer.**

(57) Frequenzsynthetisierer zur Erzeugung unterschiedlicher Kanalraster mit kurzen Einschwingzeiten arbeiten gewöhnlich nach dem Analyseprinzip (Mischer). Dazu sind mehrere Phasenregelkreise und teure Filter erforderlich. Mehrdeutigkeiten sind unvermeidbar. Bei einem Kanalraster mit Kanälen geringer Bandbreite ist die Umschaltgeschwindigkeit durch die Einschwingzeit der Phasenregelschleifen begrenzt. Der erfindungsgemäße Frequenzsynthetisierer arbeitet mit nur zwei Phasenregelkreisen (PLL1, PLL2), die beide eine Betriebsfrequenz ($f_1$, $f_2$) haben, die um ein Vielfaches größer als die Breite des Kanalrasters ist. Die Frequenzen der Phasenregelkreise werden aus einer gemeinsamen Referenzfrequenz ($f_{ref}$) abgeleitet. Durch Variation der Teilverhältnisse der im Synthetisierer vorhandenen Frequenzteiler (D1 ... D4) lassen sich unterschiedliche Kanalraster und verschiedene Arbeitsfrequenzen einstellen. Die Referenzfrequenz wird aus einem quarzgesteuerten, temperaturkompensierten Oszillator abgeleitet.

FIG.1

Die Erfindung betrifft einen Frequenzsynthetisierer, wie er beispielsweise in Funkgeräten, die nach dem Frequenzsprungverfahren (Hopping) arbeiten, verwendet wird. Ein solcher Frequenzsynthetisierer erzeugt in einem Frequenzband, z.B. bei 40 MHz, eine Vielzahl von Kanälen mit einem Frequenzabstand, der wesentlich kleiner als die Frequenz des Frequenzbandes ist, z.B. 12,5 kHz. Dadurch ergibt sich um die Frequenz von 40 MHz ein Kanalraster mit einer Breite oder mit einem Rasterabstand von 12,5 kHz.

An die Frequenz- und Phasenstabilität der vom Frequenzsynthesizer erzeugten Signale werden hohe Anforderungen gestellt. Aus diesem Grunde werden sie in Phasenregelschleifen, im folgenden auch PLL genannt, erzeugt. In der Regel benutzt man mindestens zwei Phasenregelschleifen, deren Ausgangssignale durch Mischen das Kanalraster im gewünschten Frequenzband erzeugen. Außerdem sollen die Einschwingzeiten beim Frequenzsprungverfahren beim Springen von einer Frequenz zur anderen möglichst kurz sein. Die Einschwingzeiten von Phasenregelkreisen hängen direkt mit der Frequenz zusammen, auf denen sie betrieben werden. Je höher diese Frequenzen, desto kürzer die Einschwingzeiten. Die Realisierung von Frequenzsynthetisierern mit kurzen Einschwingzeiten bereitet Schwierigkeiten, da ein das Kanalraster erzeugender PLL infolge der geringen Breite der Kanäle relativ große Einschwingzeiten hat.

Aus der EP-B1 0 273 203 ist ein Frequenzsynthetisierer bekannt, der zur Erzeugung verschiedener Sendefrequenzen und Kanalraster vier Phasenregelkreise benutzt. Der für diese Lösung erforderliche hohe Aufwand ist nachteilig. Aufgabe der Erfindung ist es, einen Frequenzsynthetisierer so auszulegen, daß er die Erzeugung unterschiedlicher Kanalraster mit einfachen Mitteln erlaubt und gleichzeitig kurze Einschwingzeiten hat. Diese Aufgabe wird gelöst durch einen Frequenzsynthetisierer mit der Merkmalskombination des Hauptanspruches.

Der erfindungsgemäße Frequenzsynthetisierer hat den Vorteil, daß neben den kurzen Einschwingzeiten die Erzeugung unterschiedlicher Kanalraster ohne Austausch von Baugruppen möglich ist. Abhängig von der Einstellung des Teilverhältnisses der im Frequenzsynthetisierer und in den beiden Phasenregelkreisen vorhandenen Frequenzteiler ergeben sich unterschiedliche Kanalraster. Ein weiterer Vorteil des erfindungsgemäßen Synthetisierers liegt darin, daß einer der beiden Phasenregelkreise im Empfangsbetrieb eines Funkgerätes als Empfängeroszillator arbeitet. In den Unteransprüchen sind vorteilhafte Ausgestaltungen der Erfindung enthalten.

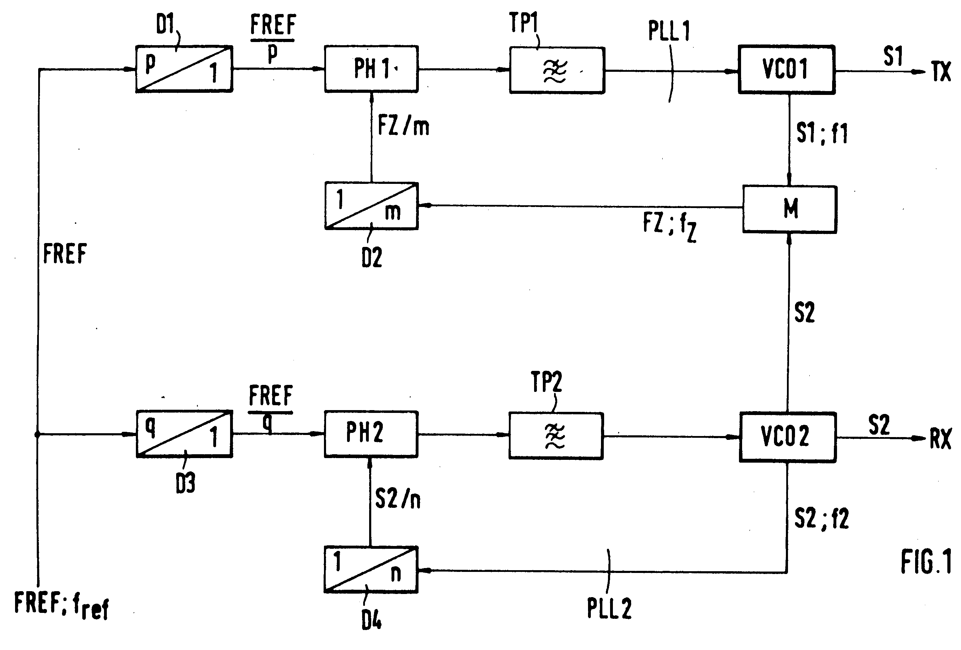

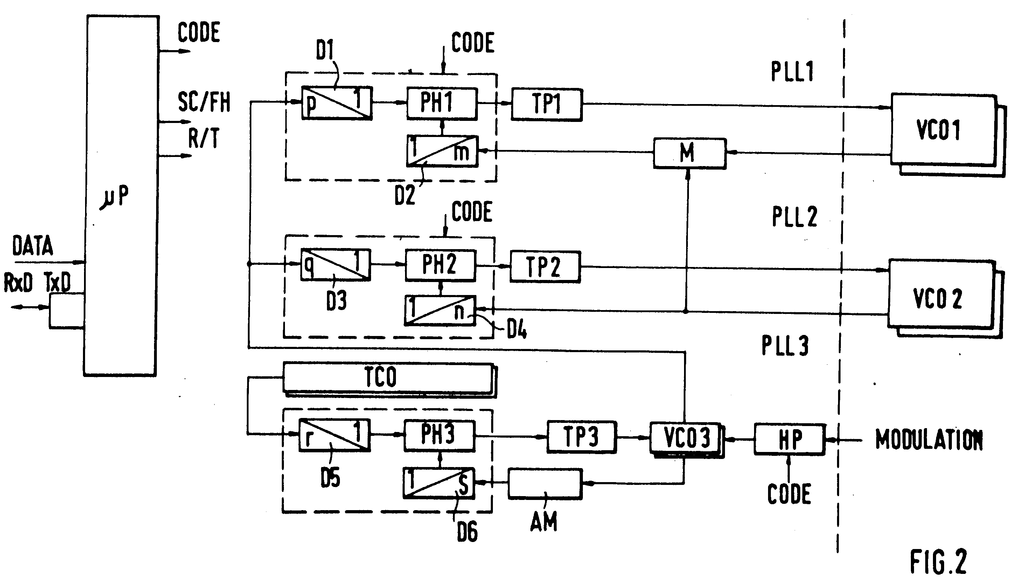

Ein Ausführungsbeispiel der Erfindung wird anhand der Figuren 1 und 2 beschrieben. Es zeigen:

Fig. 1     ein Blockschaltbild eines Frequenzsynthetisierers mit zwei Phasenregelkreisen,

Fig. 2     einen Frequenzsynthetisierer mit Steuereinrichtung und Referenzoszillator.

In Fig. 1 ist mit PLL1 ein erster Phasenregelkreis, mit PLL2 ein zweiter Phasenregelkreis bezeichnet. Der erste Phasenregelkreis PLL1 besteht aus einem ersten spannungsgesteuerten Oszillator VCO1, einem ersten Teiler D2, einer ersten Phasenvergleichseinrichtung PH1 und einem Tiefpaß TP1. Der zweite Phasenregelkreis PLL2 besteht aus einem zweiten spannungsgesteuerten Oszillator VCO2, einem zweiten Teiler D4, einer zweiten Phasenvergleichseinrichtung PH2 und einem Tiefpaß TP2. Mit D1 und D3 sind Frequenzteiler bezeichnet, die die Frequenz eines Referenzsignals FREF teilen. Zwischen den beiden spannungsgesteuerten Oszillatoren VCO1 und VCO2 befindet sich ein mit M bezeichneter Mischer. Der Frequenzsynthetisierer arbeitet wie folgt:

Das Signal FREF, das als drittes Referenzsignal bezeichnet wird, wird in den beiden Frequenzteilern D1 und D3 geteilt. Am Teiler D1 liegt das Ausgangssignal FREF/p, das als erstes Referenzsignal bezeichnet wird und das den ersten Phasenregelkreis PLL1 steuert. Am Teiler D3 liegt das Ausgangssignal FREF/q, das als zweites Referenzsignal bezeichnet wird und das den zweiten Phasenregelkreis PLL2 steuert. Das Ausgangssignal S2 des zweiten spannungsgesteuerten Oszillators VCO2 hat eine Frequenz, die wegen des zweiten Teilers D4 das n-Fache vom Signal S2/n beträgt. Für die Frequenz f2 des Ausgangssignales S2 gilt also:

$$f2 = n \cdot f_{ref} : q$$

Die Frequenz $f_Z$ des Mischsignales FZ ist das m-Fache der durch p geteilten Referenzfrequenz $f_{ref}$. Es gilt:

$$f_Z = m \cdot f_{ref} : p.$$

Da die Frequenz $f_Z$ das Ergebnis einer Mischung der Ausgangssignale S1 und S2 ist, gilt bei bekannter Frequenz des Ausgangssignales S2 und bekannter Frequenz des Mischsignales FZ:

$$f_1 = f_2 - f_Z.$$

Für die Frequenz $f_1$ des Ausgangssignales S1 gilt daher nach Einsetzen und Umformen:

$$f_1 = f_{ref} \left( \frac{n}{q} - \frac{m}{p} \right).$$

In den nachfolgenden Tabellen sind für eine Referenzfrequenz $f_{ref}$ von 9000 kHz, für q = 45, für p - 48 oder 50 und für verschiedene Werte von m und n die Frequenzen $f_1$ und $f_2$ sowie die Frequenz $f_Z$ des Mischsignales FZ zusammengestellt.

Man erkennt, daß Kanalraster mit einer Breite von 12,5 kHz oder 20 kHz erzeugt werden, ohne daß einer der verwendeten Phasenregelkreise PLL1, PLL2 auf einer Frequenz von 12,5 kHz oder 20 kHz laufen muß. Vielmehr läuft in beiden Fällen der zweite Phasenregelkreis PLL2 immer mit 200 kHz, während der erste Phasenregelkreis PLL1 einmal mit 187,5 Khz, das andere Mal mit 180 kHz arbeitet. Das bedeutet aber, daß trotz des schmalen Kanalrasters beide Phasenregelkreise eine erheblich kürzere Einschwingzeit haben, als ein Phasenregelkreis es hätte, der auf 12,5 oder 20 kHz liefe. Auch erkennt man, daß durch bloße Änderung der Teilverhältnisse der Frequenzteiler D1 bis D4 die verschiedensten Arbeitsfrequenzen mit unterschiedlichen Kanalrastern eingestellt werden können. Die Vorrichtung nach Fig. 1 eignet sich daher für einen Frequenzsynthetisierer, der sowohl unterschiedliche Kanalraster erzeugt als auch kurze Einschwingzeiten hat.

Fig. 2 zeigt einen Frequenzsynthetisierer, der nach dem in Fig. 1 dargestellten Prinzip arbeitet, darüberhinaus aber noch eine Quelle zur Erzeugung der Referenzfrequenz $f_{ref}$ und eine Steuereinrichtung zur Steuerung der Frequenzteiler enthält. Gleiche Bezugszeichen bezeichnen gleiche Elemente wie in Fig. 1. In Fig. 2 ist zusätzlich zu den beiden Phasenregelkreisen PLL1 und PLL2 ein dritter Phasenregelkreis PLL3 vorgesehen, in dem das Signal mit der Referenzfrequenz $f_{ref}$ erzeugt wird. Der Phasenregelkreis enthält einen mit VCO3 bezeichneten spannungsgesteuerten Oszillator, zwei Teiler D5 und D6, eine Phasenvergleichseinrichtung PH3 und einen Tiefpaß TP3. Weiterhin ist zwischen einem Ausgang des spannungsgesteuerten Oszillators VCO3 und dem Teiler D6 ein Verstärker AM vorgesehen. Auf die Funktionsweise des Phasenregelkreises PLL3 wird nicht näher eingegangen, da Phasenregelschleifen als solche nicht Gegenstand der Erfindung sind. Dem Fachmann auf dem Gebiete der Frequenzsynthetisierer ist der Entwurf und der Aufbau von Phasenregelkreisen geläufig. Der Phasenregelkreis PLL3 arbeitet auf einer Frequenz, die aus einem mit TCO bezeichneten Oszillator abgeleitet ist. Bei diesem Oszillator handelt es sich um einen Quarzoszillator, der in einem temperaturstabilisierten Gehäuse untergebracht ist. Weiterhin ist in Fig. 2 ein mit HP bezeichneter Hochpaß vorgesehen, über den die Eingabe eines Kodes und die Modulation der Referenzfrequenz $f_{ref}$ möglich sind.

$\mu$P bezeichnet einen Mikroprozessor, der zur Steuerung des Frequenzsynthetisierers dient. Der Mikroprozessor steuert über einen mit R/T bezeichneten Ausgang die Funktionen Empfangen und Senden des Synthetisierers. An einem mit CODE bezeichneten Ausgang steht der zum Kodieren der Nachrichten erforderliche Kode zur Verfügung. Über einen mit DATA bezeichneten Eingang wird der Mikroprozessor mit Informationen versorgt. An einer mit RxD und TxD bezeichneten Schnittstelle wird die Verbindung zu weiteren signalverarbeitenden Geräten hergestellt. Der Mikroprozessor $\mu$P erzeugt die Werte für die Zahlen p, m, q, n für das Frequenzsprungverfahren.

Tabelle I

| m | n | f1/kHz | f2/kHz | $f_Z$/kHz |
|---|---|---|---|---|
| 20 | 218 | 40000 | 43600 | 3600 |
| 21 | 219 | 40020 | 43800 | 3780 |
| 22 | 220 | 40040 | 44000 | 3960 |
| 23 | 221 | 40060 | 44200 | 4140 |
| 24 | 222 | 40080 | 44400 | 4320 |
| 25 | 223 | 40100 | 44600 | 4500 |
| 26 | 224 | 40120 | 44800 | 4680 |
| 27 | 225 | 40140 | 45000 | 4860 |
| 28 | 226 | 40160 | 45200 | 5040 |
| 29 | 227 | 40180 | 45400 | 5220 |
| 30 | 228 | 40200 | 45600 | 5400 |
| mit $f_{ref}$ = 9000 kHz, p = 50, q = 45 | | | | |

Tabelle II

| m | n | f1/kHz | f2/kHz | $f_Z$/kHz |
|---|---|--------|--------|--------|
| 16 | 215 | 40000 | 43000 | 3000 |
| 17 | 216 | 40012,5 | 43200 | 3187,5 |
| 18 | 217 | 40025 | 43400 | 3375 |
| 19 | 218 | 40037,5 | 43600 | 3562,5 |
| 20 | 219 | 40050 | 43800 | 3750 |
| 21 | 220 | 40062,5 | 44000 | 3937,5 |
| 22 | 221 | 40075 | 44200 | 4125 |
| 23 | 222 | 40087,5 | 44400 | 4312,5 |
| 24 | 223 | 40100 | 44600 | 4500 |
| 25 | 224 | 40112,5 | 44800 | 4687,5 |
| 26 | 225 | 40125 | 45000 | 4875 |

mit $f_{ref}$ = 9000 kHz, p = 48, q = 45

**Patentansprüche**

1. Frequenzsynthetisierer zur Erzeugung einer Vielzahl von Frequenzen mit einem ersten Phasenregelkreis (PLL1),
   der einen ersten spannungsgesteuerten Oszillator (VC01) enthält, und mit einem zweiten Phasenregelkreis (PLL2), der einen zweiten spannungsgesteuerten Oszillator (VC02) enthält,
   **gekennzeichnet durch** einen Mischer (M) zum Erzeugen eines Mischsignales (FZ) aus den Ausgangssignalen (S1, S2) der spannungsgesteuerten Oszillatoren (VC01, VC02), eine erste Phasenvergleichseinrichtung (PH1), die dem ersten Phasenregelkreis zugeordnet ist und ein aus dem Mischsignal (FZ) abgeleitetes Signal (FZ/m) mit einem ersten Referenzsignal (FREF/p) vergleicht, und eine zweite Phasenvergleichseinrichtung (PH2), die dem zweiten Phasenregelkreis zugeordnet ist und ein aus dem Ausgangssignal (S2) des zweiten spannungsgesteuerten Oszillators abgeleitetes Signal (S2/n) mit einem zweiten Referenzsignal (FREF/q) vergleicht.

2. Frequenzsynthetisierer nach Anspruch 1, gekennzeichnet durch einen ersten Teiler (D2) mit steuerbarem Teilverhältnis, der die Frequenz ($f_Z$) des Mischsignals (FZ) im Verhältnis m:1 teilt (m ganze Zahl).

3. Frequenzsynthetisierer nach Anspruch 1, gekennzeichnet durch einen zweiten Teiler (D4), der die Frequenz des Ausgangssignals (S2) des zweiten spannungsgesteuerten Oszillators (VC02) im Verhältnis n:1 teilt (n ganze Zahl).

4. Frequenzsynthetisierer nach Anspruch 1, gekennzeichnet durch zwei weitere Teiler (D1, D3,) von denen der eine (D1) die Frequenz ($f_{ref}$) eines dritten Referenzsignals (FREF) im Verhältnis p:1, der andere (D3) die Frequenz ($f_{ref}$) des dritten Referenzsignals im Verhältnis q:1 teilt (p, q ganze Zahlen).

5. Frequenzsynthetisierer nach Anspruch 1, gekennzeichnet durch ein in seiner Breite veränderbares Kanalraster zur Erzeugung der Vielzahl von Frequenzen.

6. Frequenzsynthetisierer nach Anspruch 1, gekennzeichnet durch Tiefpässe (TP1 und TP2) mit Grenzfrequenzen, die viel größer als die Breite des Kanalrasters sind.

7. Frequenzsynthetisierer nach Anspruch 4, gekennzeichnet durch eine quarzgesteuerte Phasenregelschleife zur Erzeugung des dritten Referenzsignals (FREF).

8. Frequenzsynthetisierer nach Anspruch 5, dadurch gekennzeichnet, daß die Frequenz des ersten und zweiten Referenzsignales (FREF/p, FREF/q) viel größer als die Breite des Kanalrasters ist.

9. Frequenzsynthetisierer nach Anspruch 5, dadurch gekennzeichnet, daß die Breite des Kanalrasters gleich der Differenz aus der Frequenz des ersten Referenzsignales (FREF/p) und der Frequenz des zweiten Referenzsignales (FREF/q) ist.

FIG.1

EP 0 549 881 A1

FIG.2

EP 0 549 881 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | US-A-3 956 703 (J. NOORDANUS  ET.  AL.)<br>* Spalte 3, Zeile 54 - Spalte 5, Zeile 23; Abbildung 4 * | 1-5,8,9 | H03L7/23 |
| Y | --- | 7 | |
| X | US-A-4 234 929 (W. RILEY)<br>* Spalte 3, Zeile 4 - Zeile 50 *<br>* Spalte 5, Zeile 41 - Zeile 47 *<br>--- | 1-5,8,9 | |
| Y | EP-A-0 393 975 (RAYTHEON COMPANY.)<br>* Seite 5, Zeile 41 - Seite 6, Zeile 2; Abbildung 2 * | 7 | |
|  | ----- | | |

RECHERCHIERTE SACHGEBIETE (Int. Cl.5 )

H03L

Der vorliegende Recherchenbericht wurde für alle Patentansprüche erstellt

| Recherchenort | Abschlußdatum der Recherche | Prüfer |
|---|---|---|
| DEN HAAG | 23 FEBRUAR 1993 | BUTLER N.A. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
............................................................................
& : Mitglied der gleichen Patentfamilie, übereinstimmendes
    Dokument

EPO FORM 1503 03.82 (P0403)